(19) Europäisches Patentamt

European Patent Office

Office européen des brevets

(11) Veröffentlichungsnummer : **0 050 328**
**B1**

(12) **EUROPÄISCHE PATENTSCHRIFT**

(45) Veröffentlichungstag der Patentschrift :
04.07.84

(51) Int. Cl.³ : **H 03 J 7/18**

(21) Anmeldenummer : **81108396.3**

(22) Anmeldetag : **16.10.81**

(54) Verfahren zum Einspeichern von digitalen Abstimmdaten von Rundfunk- und Fernsehsenderfrequenzen.

(30) Priorität : **21.10.80 DE 3039640**

(43) Veröffentlichungstag der Anmeldung :
**28.04.82 Patentblatt 82/17**

(45) Bekanntmachung des Hinweises auf die Patenterteilung : **04.07.84 Patentblatt 84/27**

(84) Benannte Vertragsstaaten :
**AT BE CH FR GB IT LI NL**

(56) Entgegenhaltungen :
**DE-A- 1 591 144**
**DE-A- 2 828 367**
**DE-A- 2 850 733**
**DE-A- 2 850 866**
**RADIOMENTOR ELECTRONIC, Band 43, Nr. 11, November 1977, Seiten 480,481, Munchen, DE.**
**FUNKSCHAU, Band 50, Nr. 18, August 1978, Seiten 74,77,78, Munchen, DE.**

(73) Patentinhaber : **SABA GmbH**
**Postfach 2060 Hermann-Schwer-Strasse 3**
**D-7730 Villingen-Schwenningen (DE)**

(72) Erfinder : **Arendt, Bodo, Ing. grad.**
**Alban-Dold-Strasse 30**
**D-7730 Villingen-Schwenningen (DE)**
Erfinder : **Otto, Bernhard, Ing. grad.**
**Überruckweg 13**
**D-7730 Villingen-Schwenningen (DE)**

## Beschreibung

### Stand der Technik

Die Erfindung geht aus von einem Verfahren zum Einspeichern von digitalen Abstimmdaten von Rundfunk- und Fernsehsenderfrequenzen, die über Programmwahltasten aus einem Speicher wieder abrufbar sind.

In der DE-A-28 28 367 wird eine Anordnung zum Einstellen eines Empfängers auf eine vorbestimmte Anzahl bevorzugter Abstimmpositionen beschrieben. Hierbei werden die in Form von Digitalsignalen abgespeicherten Abstimminformationen mit der eingestellten digitalen Abstimmung nacheinander verglichen, um festzustellen, ob diese bereits auf einem Speicherplatz abgespeichert worden sind. Auf diese Weise soll verhindert werden, daß ein und dieselbe Abstimminformation mehrfach auf verschiedenen Speicherplätzen liegt, wodurch die Kapazität des Speichers beeinträchtigt wird.

Es ist z. B. eine Empfangseinrichtung bekannt, bei der nach dem Einstellen des gewünschten Programms automatisch jeweils derjenige Sender dieses Programms ausgewählt ist, der den jeweils besseren Empfang gewährleistet (DE-B-15 91 144). Dieser Einrichtung liegt die Aufgabe zugrunde, jeweils nur das am stärksten einfallende Sendersignal der gleichen Modulation wiederzugeben, indem ein Sendersuchlauf nur dann angehalten wird, wenn ein entsprechender Sender mit der gleichen Modulation empfangen wird.

In der DE-A-27 46 282 wird ein Verkehrsfunkempfänger beschrieben, wobei unter mehreren Verkehrsfunksendern derjenige mit der jeweils höchsten Empfangsfeldstärke wiedergegeben wird, indem ein Sendersuchlauf dann unterbrochen wird, wenn ein Signal mit Sender- und Durchsagekennung empfangen wird und zusätzlich noch über eine Pegelvergleichseinrichtung festgestellt wird, daß der Hochfrequenzempfangspegel des jeweils empfangenen Senders einen vorbestimmten Sollwertpegel überschreitet.

Der vorliegenden Erfindung liegt die Aufgabe zugrunde, ein Verfahren zu finden, um den Einspeichervorgang zu automatisieren, um insbesondere das erstmalige Einstellen der Sender zu erleichtern. Diese Aufgabe wird durch die im kennzeichnenden Teil des Anspruchs angegebenen Verfahrensschritte gelöst.

Die Neueinstellung des Empfangsgerätes ist bei Wechsel des Empfangsortes, insbesondere bei tragbaren Empfangsgeräten, oftmals nicht unproblematisch. Auch mit den bekannten Suchlaufschaltungen müssen vom Benutzer des Empfängers verschiedene Handlungen vorgenommen werden, um einen Sender auf einen bestimmten Programmspeicherplatz zu legen. Es muß ein Suchlauf-Start von Sender zu Sender eingeleitet werden, nach dem Stop auf einem Sender muß eine Speichertaste betätigt werden, so daß man die Sender auf einem bestimmten Speicherplatz wiederfindet. Dabei kann es vorkommen, daß das gleiche Programm auf verschiedenen Frequenzen zu empfangen ist, wobei meistens nur ein Sender mit genügend großer Feldstärke empfangen wird und somit ein starkes Signal erzeugt. Durch die Erfindung wird der große Vorteil erzielt, daß vom Benutzer des Empfangsgerätes beim Einspeichern der Abstimmfrequenzen am gegebenen Empfangsort lediglich eine Taste zu betätigen ist, die einen automatischen Suchlauf in Gang setzt, wonach der Abstimmvorgang und Einspeichervorgang automatisch erfolgt. Durch Vergleich wird nur derjenige Sender abgespeichert, der bei gleichem Programm die größere Empfangsfeldstärke besitzt. Es wird hier also nicht nur eine doppelte Belegung gleicher Abstimmfrequenzen verhindert, wie im oben beschriebenen Stand der Technik, sondern darüberhinaus wird nur derjenige Sender abgespeichert, der unter mehreren das gleiche Programm ausstrahlenden Sendern am stärksten empfangen wird.

Dem erfindungsgemäßen Verfahren wird die Tatsache zugrunde gelegt, daß zukünftig z. B. die Fernsehsender Videotext aussenden, dessen Information bekanntlich in der vertikalen Austastlücke des Fernsehsignals enthalten ist. Diese Videotextinformation kann nutzbringend im Sinne der Erfindung von Fernsehempfängern verwendet werden, wenn diese mit einem entsprechenden Decoder ausgerüstet sind. Der Videotext-Decoder besitzt bekanntlich einen Speicher, in welchem jeweils eine Seite des Videotextes eingeschrieben werden kann. Auf den Seiten des Videotextes steht z. B. in einer Kopfzeile neben der Seitennummer, Kanalnummer, Uhrzeit auch ein Kurzzeichen der ausstrahlenden Sendergesellschaft (ARD, ZDF, SRG, TSI, ORF u.s.w.), wobei jede Sendegesellschaft auf verschiedensten Frequenzen (Kanäle) sendet. Es ist aber meistens nur ein Kanal einer Sendegesellschaft optimal zu empfangen. Dieses Kurzzeichen kann nun als Kennungssignal zur Durchführung des angemeldeten Verfahrens ausgenutzt werden.

### Beschreibung

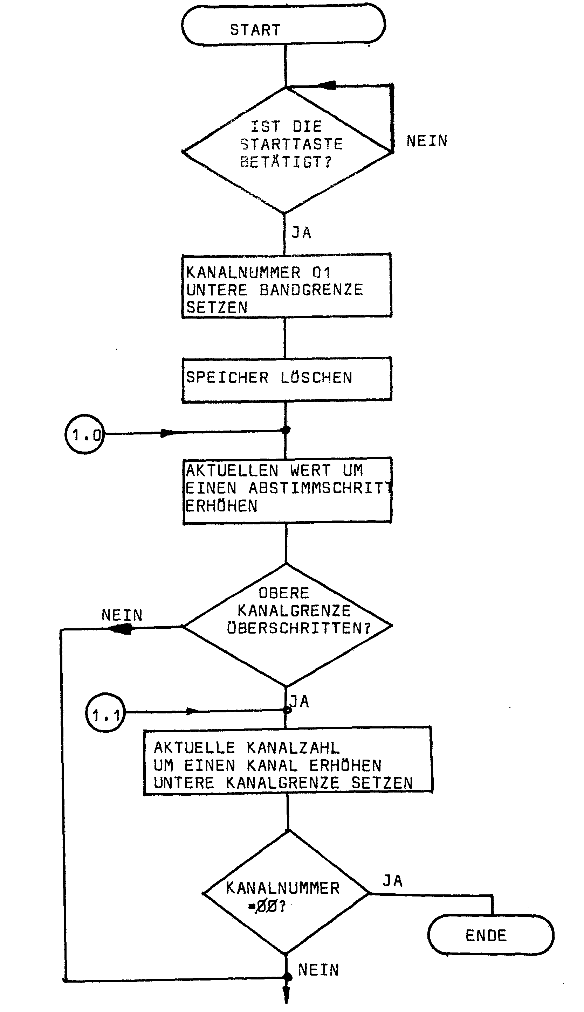

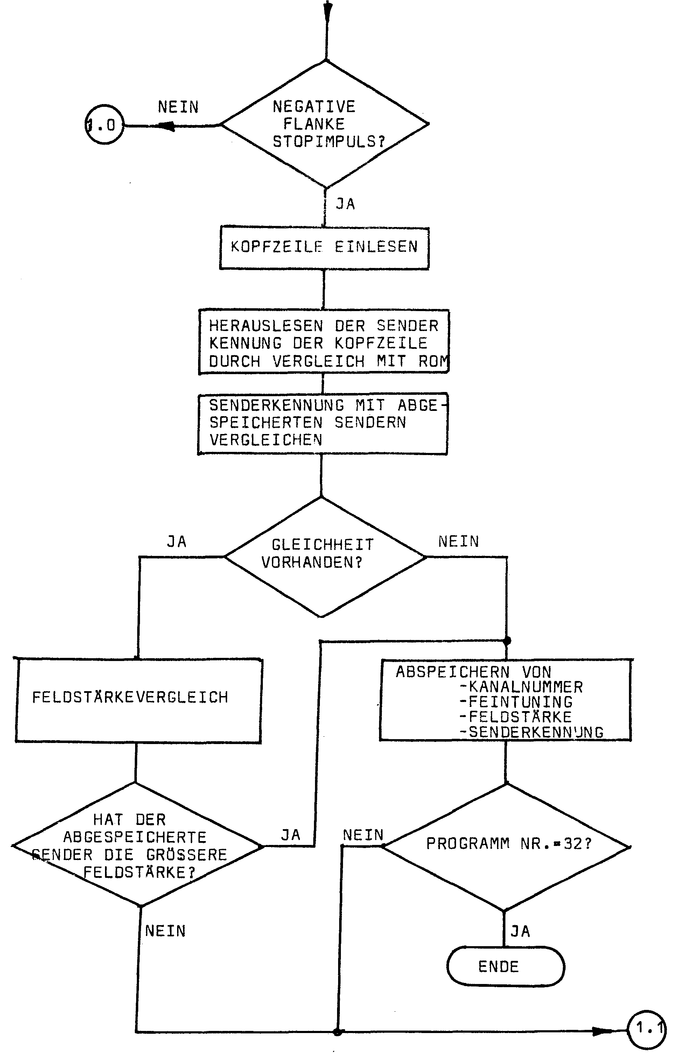

Nachstehend soll die Erfindung näher erläutert werden, wobei die einzelnen Schritte des Verfahrens in der Figur übersichtlich aufgezeichnet sind. Das Verfahren ist insbesondere für eine Mikroprozessorsteuerung geeignet. Deshalb sei der Ablauf der Steuerung mit Hilfe eines Flußdiagramms erläutert.

Zunächst wird festgestellt, ob der Benutzer des Empfangsgerätes den automatischen Einspeichervorgang durch eine Tastenbetätigung in Gang gesetzt hat. In diesem Fall beginnt der Suchlauf mit der ersten Kanalnummer an seiner unteren Bandgrenze, gleichzeitig werden sämtliche im Programmspeicher abgelegten alten Informationen gelöscht. Der Programmspeicher möge z. B. 32 Programmspeicherplätze besitzen. Sodann wird der Suchlauf in diskreten Abstimmschritten fortgesetzt, bis die obere Bandgrenze des betreffenden Kanals erreicht ist, worauf die Kanalzahl um 1 erhöht wird. Der Suchvorgang wiederholt sich von Kanal zu Kanal, bis festgestellt wird, ob der letzte Kanal nach Sendern vollständig abgesucht ist, wonach der Vorgang gestoppt wird.

Normalerweise werden jedoch in einigen Kanälen Sender liegen, so daß die negative Flanke eines Stop-Impulses festgestellt wird. In diesem Fall erhält der Videotext-Decoder den Befehl, die Kopfzeile der ersten Seite der von dem betreffenden Sender ausgestrahlten Videotext-Information auszulesen und in den Seitenspeicher einzuschreiben. In dieser Kopfzeile befindet sich, wie oben ausgeführt, die Senderkennung, die mit bereits im Programmspeicher abgespeicherten Informationen verglichen wird. Falls ein Sender mit gleichem Kennungssignal festgestellt wird, wird geprüft, welcher Sender die größere Feldstärke besitzt. Dazu ist es notwendig, daß in den Programmspeicherplätzen Abstimmdaten abgespeichert werden, die die Kanalnummer, die Abstimmspannung, die Feldstärke und die Senderkennung beinhalten. Besitzt der neu gefundene Sender die größere Feldstärke, wird dieser auf den gleichen Speicherplatz des zuerst abgespeicherten Senders gelegt, so daß jeweils immer der stärkste Sender des gleichen Programms im Programmspeicher abgelegt ist. Ist jedoch die Feldstärke des neu gefundenen Senders geringer als diejenige des bereits eingespeicherten, so wird der gefundene Sender nicht berücksichtigt und der Suchlauf wird in den nächsten Kanälen bis zum Erscheinen eines neuen Stop-Impulses wiederholt, worauf sich die soeben beschriebenen Vorgänge erneut abspielen.

Wenn entweder sämtliche Kanäle nach Sendernabgesucht worden sind, oder wenn vorher sämtliche Speicherplätze des Programmspeichers belegt worden sind, wird der Einspeichervorgang automatisch unterbrochen.

Durch das soeben beschriebene Verfahren wird erreicht, daß der Benutzer des Gerätes bei Inbetriebnahme an einem beliebigen Empfangsort durch einfachen Tastendruck in kürzester Zeit und ohne komplizierte Manipulationen den bisher oft langwierigen Einstellvorgangs selbsttätig vornehmen kann.

Die Beschreibung bezieht sich auf Fernsehempfänger mit Videotextwiedergabe. Es kann jedoch auch ein im Fernsehsignal enthaltenes beliebiges anderes die Sender unterscheidendes Kennungssignal Verwendung finden, welches z. B. in den Leerzeilen des Vertikalimpulses mitgesendet wird.

Bei Anwendung der Erfindung auf Rundfunkempfänger kann das Kennungssignal z. B. in einem zusammen mit einem Pilotton ausgestrahlten Frequenzspektrum enthalten sein, wie es bei Rundfunksignalen mit Verkehrsfunk üblich ist. Durch Abrufen der einzelnen Speicherplätze kann der Empfänger anschließend feststellen, welche Sender abgespeichert wurden, da die Kennung, z. B. die Sendernamen mit abgespeichert sind, und in einer Anzeige wiedergegeben werden können.

## Anspruch

Verfahren zum Einspeichern von digitalen Abstimmdaten in einen neu formierbaren Speicher zur Abstimmung von Rundfunk- und Fernsehempfangsgeräten, wobei die in den Speicherplätzen abgespeicherten Daten über Programmwahltasten abrufbar sind und die Abstimmdaten eines Senders vor dem Abspeichern mit den in dem Speicher bereits abgespeicherten Daten auf Übereinstimmung verglichen werden und wobei der jeweils stärkere und gleiches Programm ausstrahlende Sender abgespeichert wird, dadurch gekennzeichnet, dass ein automatischer Sendersuchlauf gestartet wird, der am unteren Ende des empfangsfrequenzbereichs beginnend, jeweils bei Auftreten eines Stopsignals bei Erreichen einer Empfangsfrequenz anhaltend, am anderen Ende des Frequenzbereichs endet, wobei nach jedem Stopimpuls die Abstimmdaten, bestehend aus einem dem Sender zugeordneten Kennungssignal, dessen Empfangsfeldstärke sowie aus der der empfangsfrequenz bzw Kanalnummer entsprechenden Abstimmspannung digital mit den bereits abgespeicherten Daten verglichen wird und dass der jeweils stärkere Sender mit dem gleichen Kennungssignal abgespeichert wird, wonach der Sendersuchlauf automatisch erneut gestartet wird, bis er entweder bei Erreichen des oberen Endes des Empfangsbereichs oder bei Belegung sämtlicher zur Verfügung stehender Speicherplätze beendet wird.

## Claim

Process for the storage of digital tuning data into a newly formed memory for the tuning of radio- and television-receiving-sets, whereby the data stored in the storage positions are being recallable by means of program select keys and the tuning data of a station are being compared to agree with data stored in the memory prior to storage and whereby each time the stronger station propagating the same program is being stored, characterized in that a automatic station finder is being started, which begins at a lower end of the range of received frequencies, stopping each time when receiving a stop signal at reaching of a received frequency up to the other end of the range of received frequencies, whereby after each stop puls the tuning information existing of identification signal related to the one station, his received field strength as well as the tuning voltage corresponding with the received frequency are being compared digitally with the data already stored, and that each time the stronger station with the same identification signal is being stored, whereafter the station finder is newly started until the same either reaches the upper end of the received range of frequencies or, when all storage positions ared filled, such the station finder is being completed.

**Revendication**

Procédé pour le stockage de données numériques d'accord dans une mémoire reconformable pour l'accord d'appareils récepteurs de radiodiffusion et de télévision, où les données emmagasinées dans les emplacements de mémoire peuvent être appelées au moyen de touches de sélection de programmes, et où les données d'accord d'un émetteur sont comparées pour concordance, en choisissant chaque fois l'émetteur rayonnant le même programme avec l'intensité la plus forte, caractérisé en ce qu'une recherche automatique d'émetteur est déclenchée qui commence à une extrémité inférieure de la plage de fréquences de réception, stoppe chaque fois à l'apparition d'un signal d'arrêt lorsqu'on parvient à une fréquence de réception, et se termine à l'autre extrémité de la plage de fréquences, cette recherche étant telle que, après chaque impulsion d'arrêt, l'information d'accord, consistant en un signal d'identification attribué à l'émetteur, dont l'intensité du champ de réception ainsi que la tension d'accord correspond à la fréquence de réception, est comparée numériquement avec les données déjà emmagasinées, et en ce que chaque fois l'émetteur plus intense est stocké avec le même signal d'identification, après quoi la recherche automatique d'émetteur repart, jusqu'à ce qu'elle se termine, soit en atteignant l'extrémité supérieure de la plage de réception, soit par l'occupation de tous les emplacements de mémoire disponibles.

**0 050 328**

START

IST DIE STARTTASTE BETÄTIGT? — NEIN

JA

KANALNUMMER 01
UNTERE BANDGRENZE
SETZEN

SPEICHER LÖSCHEN

1.0

AKTUELLEN WERT UM
EINEN ABSTIMMSCHRITT
ERHÖHEN

OBERE
KANALGRENZE
ÜBERSCHRITTEN? — NEIN

JA

1.1

AKTUELLE KANALZAHL
UM EINEN KANAL ERHÖHEN
UNTERE KANALGRENZE SETZEN

KANALNUMMER
=ØØ? — JA

ENDE

NEIN

1

**0 050 328**

NEIN ←──── NEGATIVE FLANKE STOPIMPULS? ───(9.0?)

JA

KOPFZEILE EINLESEN

HERAUSLESEN DER SENDER KENNUNG DER KOPFZEILE DURCH VERGLEICH MIT ROM

SENDERKENNUNG MIT ABGE-SPEICHERTEN SENDERN VERGLEICHEN

JA ←──── GLEICHHEIT VORHANDEN? ────→ NEIN

FELDSTÄRKEVERGLEICH

ABSPEICHERN VON
 -KANALNUMMER
 -FEINTUNING
 -FELDSTÄRKE
 -SENDERKENNUNG

HAT DER ABGESPEICHERTE SENDER DIE GRÖSSERE FELDSTÄRKE? ──── JA

NEIN ──── PROGRAMM NR.=32?

NEIN

JA

ENDE

(1.1)

2